# EUROPEAN PATENT APPLICATION

(11) **EP 4 848 975 A2**
(43) Date of publication of application: **02.12.2026**
(21) Application number: 26166787.7
(22) Date of filing: 23.03.2026
(51) Int. Cl.: H10W 74/10, G01R 15/20, H10W 70/40

(54) **ISOLATION STRUCTURE AND RELATED TECHNIQUES**

(30) Priority: 27.05.2025 US 202519219039
(71) Applicant: Allegro MicroSystems, LLC, Manchester, NH 03103-3353 (US)
(72) Inventor: SHEWMON, Nathan, 38114 Braunschweig (DE); HARBINSON, Mark, Goffstown, 03045 (US); ROCK, Simon E., 69123 Heidelberg (DE); GILLET, Cédric, 74000 Annecy (FR)
(74) Representative: South, Nicholas Geoffrey

(57) **Abstract**

According to one aspect of the present disclosure, an isolation structure comprises a crown having an opening therein with the opening having a shape selected such that the crown may be disposed over an integrated circuit (IC), the crown having an outer shape selected to increase creepage and clearance distances between a low-voltage conductor of an IC and a high-voltage conductor proximate the IC. In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC.

## Description

### CROSS-REFERENCE TO RELATED APPLICATIONS

Not Applicable.

### STATEMENT REGARDING FEDERALLY SPONSORED RESEARCH

Not Applicable.

### FIELD

The present disclosure relates generally to voltage isolation structures and more particularly to voltage isolation structures suitable for use with current sensor integrated circuits (ICs).

### BACKGROUND

Some conventional circuit components include electrical current sensors with one or more magnetic field sensing elements positioned near a current-carrying conductor to sense a magnetic field generated as a result of current flowing through the conductor. The current sensor generates an output signal having a magnitude proportional to the magnetic field induced by the current through the conductor.

Voltage isolation can be used for electronic packages having circuit components with two separate voltage levels connected to the electrical connections of the package. A required spacing distance between components to withstand a given working voltage is specified in terms of "creepage" and "clearance." The term clearance refers to the shortest distance through air between two conductive parts (e.g., the path that a spark may take). The term creepage refers to the shortest distance between two conductive parts along a surface of any insulation material common to both parts (for example, the distance between high-voltage and low-voltage conductors along a surface). Meeting specified creepage and clearance requirements can become challenging, especially in high-voltage applications, where longer creepage and clearance distances are often called for.

### SUMMARY OF DISCLOSED EMBODIMENTS

Described herein is a voltage isolated integrated circuit (IC) package including an isolation structure disposed over an IC. The isolation structure increase creepage and clearance distances between a low-voltage conductor of an IC and a high-voltage conductor proximate the IC. The isolation structure facilitates the improvement of the sensors misplacement error, which occurs when the IC moves relative to the conductor, resulting in a near constant sensitivity. With the described arrangements, a highly repeatable, tightly controlled, voltage isolated, accurate current IC performance is achieved.

According to one aspect of the present disclosure, an isolation structure comprises a crown having an opening therein with the opening having a shape selected such that the crown may be disposed over an integrated circuit (IC), the crown having an outer shape selected to increase creepage and clearance distances between a low-voltage conductor of an IC and a high-voltage conductor proximate the IC. In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC.

In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC and the flange further comprises one or more clips to position and hold the isolation structure.

In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC and one or more screws that extend through the flange to position the isolation structure in relation to the IC and the high-voltage conductor. In some embodiments, the crown further comprises one or more extended portions to position and hold the isolation structure. In some embodiments, the isolation structure further comprises an adhesive material disposed on the crown.

According to another aspect of the present disclosure, a voltage isolated integrated circuit (IC) package comprises an IC. In some embodiments, the IC comprises: a lead frame comprising a die attach pad and a plurality of elongated leads extending in a single direction with respect to the die attach pad; a semiconductor die comprising a first surface attached to the die attach pad and a second, opposing surface; and a plurality of magnetic field sensing elements disposed on the second, opposing surface of the semiconductor die. In some embodiments, the voltage isolated integrated circuit (IC) package comprises an isolation structure comprising a crown having an opening therein having a shape selected such that the crown may be disposed over the IC the crown having an outer shape selected to increase creepage and clearance distances between a low-voltage conductor of an IC and a high-voltage conductor proximate the IC.

In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC. In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC and the flange further comprises one or more clips to position and hold the isolation structure. In some embodiments, the isolation structure further comprises a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC and one or more screws that extend through the flange to position the isolation structure in relation to the IC and the high-voltage conductor. In some embodiments, the crown further comprises one or more extended portions to position and hold the isolation structure. In some embodiments, the voltage isolated integrated circuit (IC) package further comprises an adhesive material disposed on the crown.

According to another aspect of the present disclosure, a configuration comprises a substrate; an integrated circuit (IC) disposed adjacent to the substrate. In some embodiments, the IC comprises: a lead frame comprising a die attach pad and a plurality of elongated leads extending in a single direction with respect to the die attach pad, wherein a terminal end of each of the plurality of elongated leads is attached to the substrate; a semiconductor die comprising a first surface attached to the die attach pad and a second, opposing surface; and a plurality of magnetic field sensing elements disposed on the second, opposing surface of the semiconductor die. In some embodiments, a configuration comprises a conductor having a first major surface, a second opposing major surface, and a slot extending through the conductor from the first major surface to the second opposing major surface, wherein the semiconductor die extend through the slot and each of the plurality of magnetic field sensing elements is configured to sense a magnetic field generated by a current through the conductor; and an isolation structure comprising a crown disposed over the IC between the conductor and the semiconductor die, the isolation structure having a shape configured to increase creepage and clearance distances between the IC and the conductor.

In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor. In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor and the flange is disposed on the second opposing major surface of the conductor, on a first surface of the substrate, between the second opposing major surface of the conductor and a first surface of the substrate, or on the second opposing major surface of the conductor and on a first surface of the substrate. In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor and one or more clips disposed on the first surface of the substrate and attached to the flange to position and hold the isolation structure.

In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor and one or more screws that extend from a second surface of the substrate to the first surface of the substrate, through the flange, and the first major surface and the second opposing major surface of the conductor to position and hold the isolation structure. In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor and the substrate further comprises a plurality of slots that extend from a first surface of the substrate to a second surface of the substrate and the flange further comprises a plurality of pillars with one or more extended portions disposed on the second surface of the substrate to position and hold the isolation structure.

In some embodiments, the isolation structure further comprises a flange that extends from a surface of the crown in a direction away from a surface of the IC, wherein an outer shape of the crown and an outer shape of the flange are selected to increase creepage and clearance distances between the IC and the conductor and the substrate further comprises a slot that extends from a first surface of the substrate to a second surface of the substrate, wherein the crown extends through the slot and the plurality of elongated leads extend through the slot and the terminal end of each of the plurality of elongated leads attach to the second surface of the substrate. In some embodiments, the crown further comprises one or more extended portions disposed on the first major surface to position and hold the isolation structure.

### DESCRIPTION OF THE SEVERAL VIEWS OF THE DRAWINGS

The manner and process of making and using the disclosed embodiments may be appreciated by reference to the figures of the accompanying drawings. It should be appreciated that the components and structures illustrated in the figures are not necessarily to scale, emphasis instead being placed upon illustrating the principles of the concepts described herein. Like reference numerals designate corresponding parts throughout the different views. Furthermore, embodiments are illustrated by way of example and not limitation in the figures, in which:
FIG. 1A is a perspective view of a current sensor integrated circuit (IC);
FIG. 1B is an exploded view of the current sensor IC of FIG. 1A;
FIGS. 2A-2B are perspective views of a voltage isolated integrated circuit (IC) package including an isolation structure disposed over an IC between a substrate and a conductor;
FIGS. 2C-2D are perspective views of the isolation structure of FIGS. 2A-2B;
FIG. 3 is a side view of a voltage isolated IC package including an isolation structure with a crown disposed over an IC between a substrate and a conductor;
FIG. 4 is a side view of a voltage isolated IC package including an isolation structure disposed over an IC between a substrate and a conductor, the isolation structure including a flange disposed adjacent to a surface of the conductor;
FIG. 5 is a side view of a voltage isolated IC package including an isolation structure disposed over an IC between a substrate and a conductor, the isolation structure including a flange disposed adjacent to a surface of the substrate;
FIG. 6 is a side view of a voltage isolated IC package including an isolation structure disposed over an IC between a substrate and a conductor, the isolation structure including a flange disposed between the conductor and the substrate;
FIG. 7 is a side view of a voltage isolated IC package including an isolation structure disposed over an IC between a substrate and a conductor, the isolation structure including a flange substantially in contact with a surface of the conductor and a surface of the substrate;
FIG. 8 is an exploded view of a configuration including an IC disposed on a substrate, with one or more clips disposed on the substrate and configured to accept and position an isolation structure;
FIG. 9A is a perspective view of a voltage isolated IC package including an isolation structure disposed over an IC between a substrate and a conductor, the isolation structure including a flange substantially in contact with a surface of the conductor and a surface of the substrate and a plurality of screws;
FIGS. 9B-9C are perspective views of the isolation structure of FIG. 9A;
FIG. 10 is a perspective view of a voltage isolated IC package including an isolation structure disposed over an IC between a substrate and a conductor, the isolation structure including a flange disposed adjacent to a first major surface of the substrate and a plurality of screws;
FIG. 11 is a side view of a voltage isolated IC package including an isolation structure with a crown disposed over an IC between a substrate and a conductor with an adhesive disposed on the crown and a first major surface of the substrate;
FIG. 12 is a side view of a voltage isolated IC package including an isolation structure with a crown disposed over an IC through a slot in a substrate and a slot in a conductor, with an adhesive disposed on the crown and the slot in the substrate;
FIGS. 13A-13C is a side view of a fabrication method to form a voltage isolated IC package, the voltage isolated IC package including an isolation structure with a crown with one or more extended portions disposed over an IC between a substrate and a conductor; and
FIGS. 14A-14C are a series of side views illustrating a fabrication method to form a voltage isolated IC package having an isolation structure with a flange and a plurality of pillars with one or more extended portions disposed over an IC between a substrate and a conductor.

### DETAILED DESCRIPTION

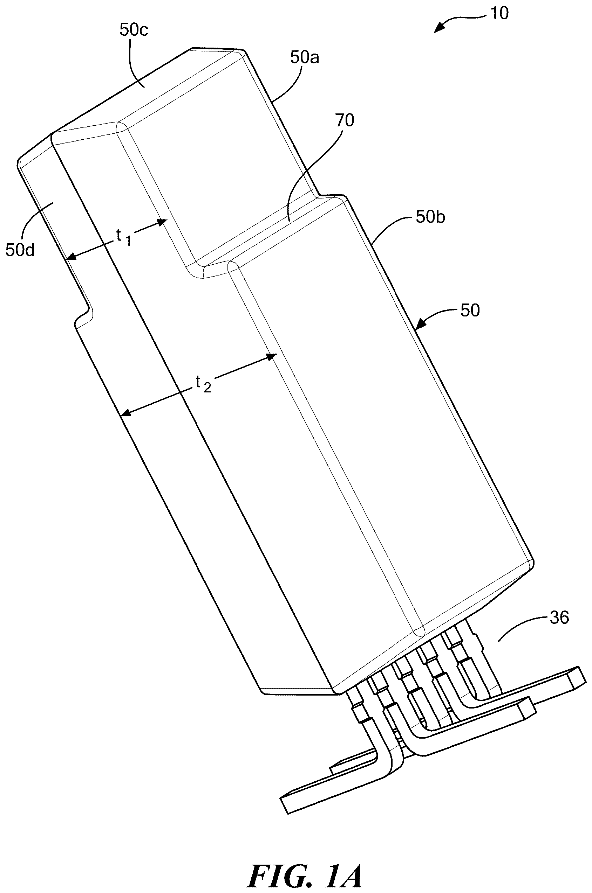

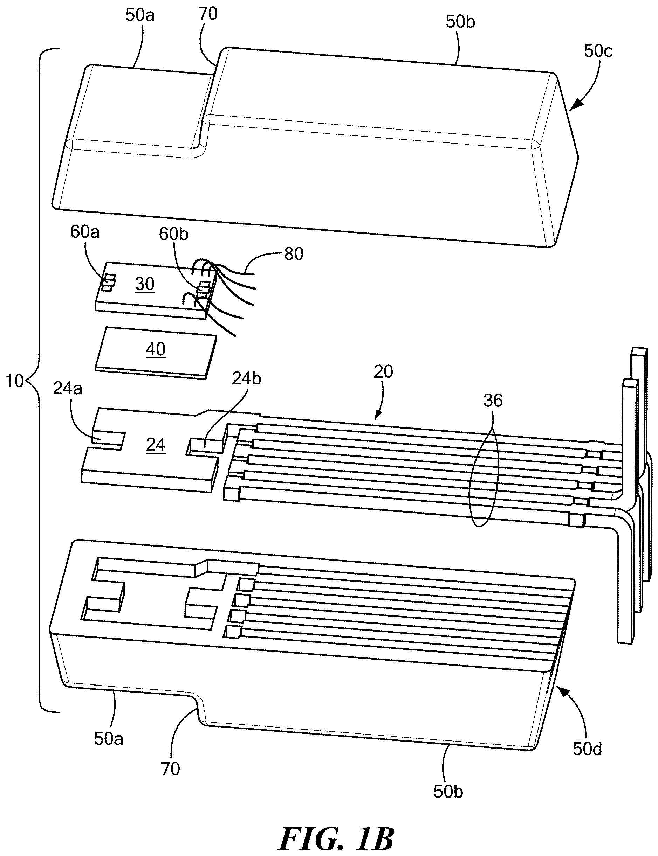

Referring to FIGS. 1A and 1B, a current sensor integrated circuit (IC) 10 includes a lead frame 20, a semiconductor die 30, and a non-conductive mold material 50 enclosing the die and a portion of the lead frame. As shown in FIG. 1B, the lead frame 20 has a die attach pad 24 and a plurality of elongated leads 36 that extend in a single direction from the die attach pad 24. The semiconductor die 30 has a first surface attached to the die attach pad 24 and a second, opposing surface supporting a plurality of magnetic field sensing elements 60a, 60b. The non-conductive mold material 50 encloses the semiconductor die 30 and the die attach pad 24 of the lead frame 20.

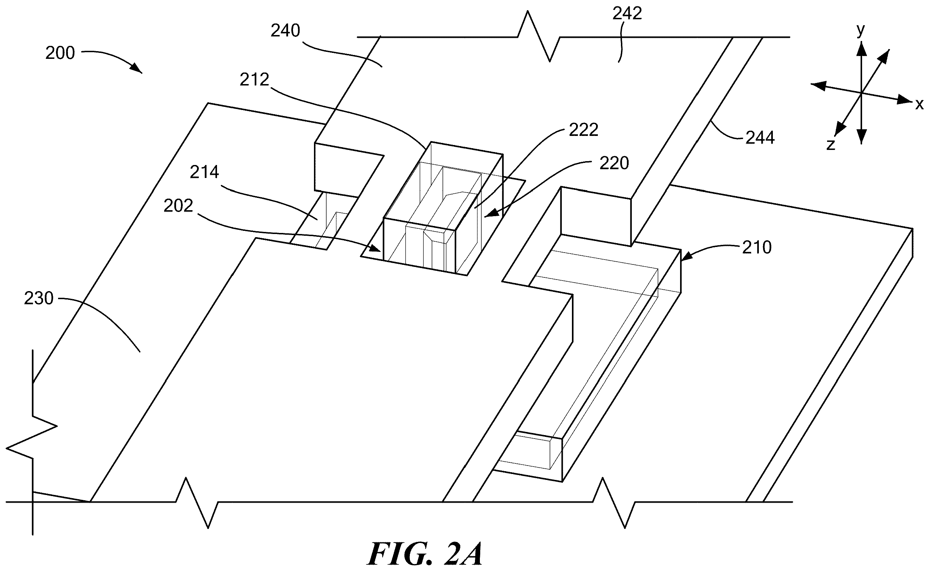

In use, the current sensor IC 10 may be positioned proximate to a current conductor (e.g., as shown in FIGS. 2A-2B) and the magnetic field sensing elements 60a, 60b sense a magnetic field generated by a current flow through the conductor. An output signal of the current sensor IC 10 is indicative of the sensed current and can be coupled to external circuits and/or systems by one or more of the elongated leads 36 configured for coupling to a substrate, such as a printed circuit board (PCB). The current conductor can take various forms, such as a bus bar as shown in FIGS. 2A-2B as will be described. Suffice it to say here that mechanical mounting tolerances that affect positioning of the magnetic field sensing elements 60a, 60b with respect to the conductor can adversely affect the accuracy of current sensor measurements and features described herein tighten mechanical mounting tolerances thereby improvising current sensing accuracy.

In embodiments, current sensor IC 10 implements differential sensing, meaning the magnetic field generated by the current through the conductor is sensed by at least two spaced sensing elements 60a, 60b that experience opposite polarities of the magnetic field. A sensor output signal that is indicative of the current through the conductor can be generated by computing a difference between the magnetic field signals. This arrangement can provide immunity to the adverse effects of stray magnetic fields.

More particularly, the plurality of magnetic field sensing elements can include at least two magnetic field sensing elements 60a, 60b, each configured to generate a respective magnetic field signal indicative of a sensed magnetic field. The semiconductor die 30 can support circuitry responsive to the magnetic field signals from the at least two magnetic field sensing elements 60a, 60b and configured to generate a current sensor output signal based on a difference between the magnetic field signals from the at least two magnetic field sensing elements. When positioned in a current sensor system (e.g., as shown in FIGS. 2A-2B), the sensing elements 60a, 60b can be positioned with respect to the conductor in a way that presents the magnetic field of a first polarity to one sensing element and of a second, opposite polarity to the other sensing element as will be described.

With the described current sensor package arrangement including elongated leads 36 extending in a single direction from the die attach pad 24, mounting flexibility is achieved which facilitates meeting tight mounting tolerances. Further, meeting tight mounting tolerances can improve current sensing accuracy.

A first portion 50a of the non-conductive mold material 50 encloses the semiconductor die 30 and the die attach pad 24 of the lead frame 20 and a second portion 50b of the non-conductive mold material 50 encloses a portion of the elongated leads 36. According to an aspect of the disclosure, the non-conductive mold material 50 includes a wing structure 70 between the first portion 50a and the second portion 50b.

The wing structure 70 can facilitate mounting the current sensor IC 10 with respect to the proximate conductor in a consistent, repeatable, and accurate manner. Suffice it here to say that the wing structure 70 facilitates meeting tight mounting tolerances by providing a consistent distance between the conductor and PCB, as can reduce sensing errors and improve the resulting current sensing accuracy. As will become apparent, the wing structure 70 can establish a conductor to substrate creepage that is a shortest distance between the current conductor and the substrate to which the current sensor is mounted. Maintaining minimum creepage distances is important to meet required voltage isolation requirements.

Referring also to FIG. 1A, the packaged current sensor IC 10 is shown with the non-conductive mold material portions 50c, 50d molded together. Wing structure 70 separates the first portion 50a of the mold material 50 from the second portion 50b of the mold material. In embodiments, the first portion 50a of the non-conductive mold material 50 has a dimension smaller than a dimension of the second portion 50b of the non-conductive mold material, as shown. For example, a thickness t1 of the first mold portion 50a can be less than a thickness t2 of the second mold portion 50b.

Referring to FIG. 1B, an exploded view of the current sensor IC 10 illustrates that the non-conductive mold material 50 can be formed in a plurality of portions, here two portions 50c, 50d, such as by transfer molding. Mold portion 50d can have indentations designed to receive lead frame 20, as shown. Further, the current sensor IC 10 can include a die attach material 40, as may take the form of a wafer backside coating for example. Die attach material 40 can be screen printed on the backside of the wafer forming the semiconductor die 30. Also shown in FIG. 1B are wire bonds 80 with which elements and circuitry supported by the substrate can be attached to leads 36.

The magnetic field sensing elements 60a, 60b and other circuitry supported by the semiconductor die 30 can be coupled to external circuits and/or systems by one of more of the elongated leads 36. Wire bonds 80 can electrically couple elements and circuitry supported by the semiconductor die 30 to the leads 36, as shown. It will be appreciated by those of ordinary skill in the art that bond pads can be provided on the semiconductor die 30 and plated areas on the leads 36 to facilitate wire bond attachment, such as by thermosonic, ultrasonic or thermocompression bonding method.

Referring also to FIG. 1B, each of the elongated leads 36 of lead frame 20 has a first end proximate to the die attach pad 24 and a second end distal from the die attach pad. While the IC 10 is shown to have five elongated leads 36, it will be appreciated that other numbers and configurations of leads are possible. In the illustrated embodiment, lead 46 is coupled to the die attach pad 24, as shown.

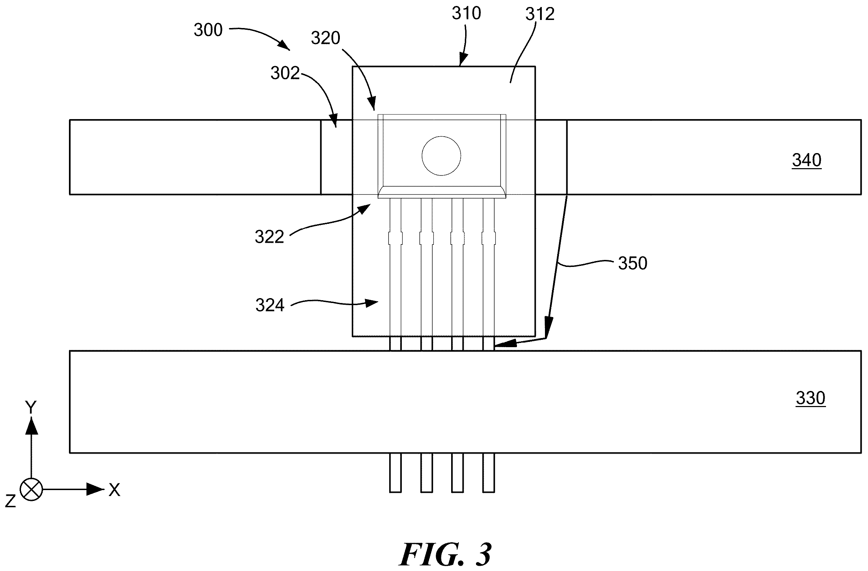

The terminal ends of the elongated leads 36 are configured for electrical connection to a substrate, such as a printed circuit board (PCB) (e.g., substrate 230 shown in FIGS. 2A-2B). Ends of the elongated leads 36 can be formed according to the type of mounting desired. For example, lead ends can be bent as shown in FIGS. 2A-2B for surface mount attachment to a PCB. Alternatively, as shown in FIGS. 3-7, ends of the elongated leads 36 can be straight for through-hole mounting to a PCB.

The die attach pad 24 can have notches 24a, 24b that are substantially vertically aligned with magnetic field sensing elements 60a, 60b in assembly. For example, as shown in FIG. 1B, notch 24a can be substantially vertically aligned with magnetic field sensing element 60a and notch 24b can be substantially vertically aligned with magnetic field sensing element 60b. Notches 24a, 24b can reduce adverse effects of eddy currents on the lead frame.

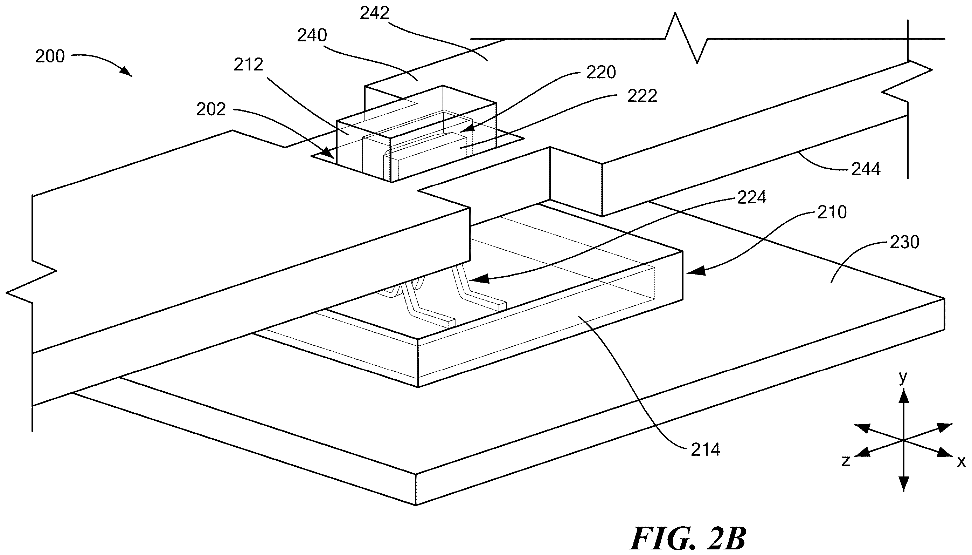

FIGS. 2A-2D show an IC 220 inserted through an opening or slot 202 in a voltage carrying conductor 240 (which may be referred to herein as a "bus bar"). Leads 224 of IC 220 are coupled to conductors on a substrate 230 which may, for example, be provided as a printed circuit board (PCB). In embodiments, IC 220 may be provided as a sensor IC and in embodiments may be similar to or the same as the packaged current sensor IC 10 described above in conjunction with FIGS. 1A-1B. Disposed over IC 220 is an isolation structure 210 (which is made transparent in FIGS. 2A, 2B so that IC 220 is visible). As will be described in detail below, isolation structure 210 has a shape configured both to accept (e.g., fit over) an IC (such as IC 220) and increase creepage and clearance distances between the IC 220 and the conductor 240. Thus, disposing isolation structure 210 over IC 220 results in a voltage isolated IC package 200.

The conductor 240 has a first major surface 242, a second opposing major surface 244, and a slot 202 extending through the conductor 240 from the first major surface 242 to the second opposing major surface 244 generally through the direction of the -y axis. The conductor 240 can be a voltage carrying conductor. In embodiments the conductor 240 may be referred to as a high-voltage conductor (e.g., a conductor carrying a voltage of about 50V for alternating current (AC), or a voltage of about 120V for direct current (DC)). It should of course be appreciated that in this context high voltage may refer to any voltage which may affect a sensor (such as sensor 220) proximate the conductor.

In embodiments, IC 220 may comprise a package 222 disposed around a lead frame comprising a die attach pad and a plurality of elongated leads 224 extending in a single direction with respect to the die attach pad (e.g., as described above in FIGs. 1A, 1B in conjunction with the current sensor IC 10). A semiconductor die including a first surface is attached to the die attach pad and a plurality of magnetic field sensing elements are disposed on the second, opposing surface of the semiconductor die. The IC 220 can include a low-voltage conductor (e.g. a conductor carrying a voltage less than 50V, e.g., 3.3V, 5V, 48V). A terminal end of each of the plurality of elongated leads 224 extends out of the package 222 generally along the direction of the -y axis and is attached to the substrate 230. The elongated leads 224 can be bent such that a portion of the elongated leads 224 extend generally along the direction of the y-axis away from the IC 220. The bent portion of the elongated leads 224 can be coupled (either directly or indirectly) to the substrate 230. The substrate 230 can be a PCB.

The semiconductor die portion of IC 200 extends into slot 202 generally through the direction of the -y axis. Each of the plurality of magnetic field sensing elements is configured to sense a magnetic field generated by a current through the conductor 240.

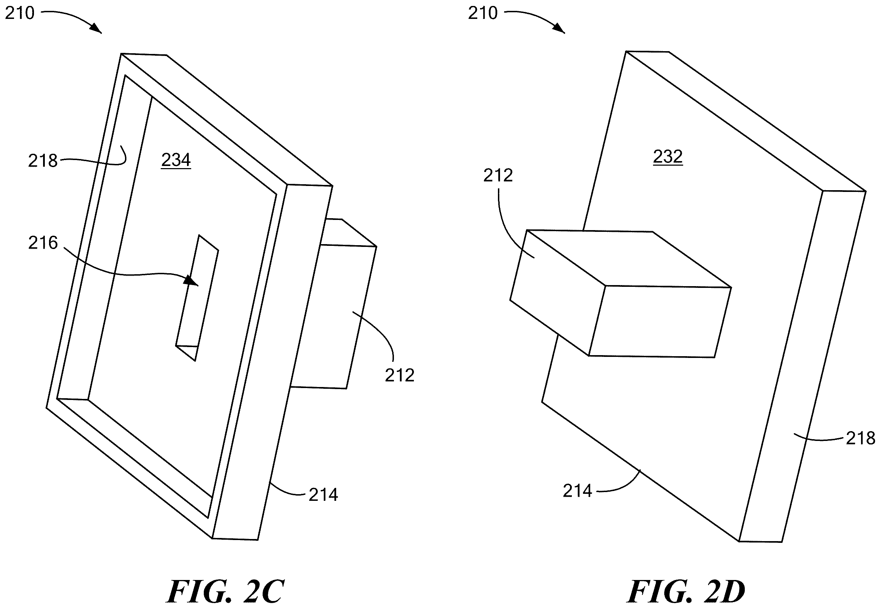

Isolation structure 210 includes a crown portion 212 (or more simply "crown 212") and an optional flange portion 214 (or more simply "flange 214"). Crown 212 is disposed over the IC 220 and thus Isolation structure 210 is arranged between one or more surfaces of the conductor 240 and one or more semiconductor die provided as part of IC 200. The isolation structure 210 includes crown 212 having an opening 216 (FIG. 2C) therein. The opening 216 has a shape selected such that crown 212 may be disposed over the IC 220. The shape of the opening 216 may be selected to form a gap between the surface area of the IC 220 and the crown 212. The gap may enable varying tolerances and/or adjustment in the size and/or shape of the IC 220 (i.e., isolation structure 210 can be positioned over ICs having varying sizes and/or shapes). Alternatively, substantially all of the surface area of the isolation structure 210 can be in contact with the conductor 240 and/or the opening 216 may be closely disposed over IC 220 (i.e., a press fit, prompting tight tolerances).

In the example embodiment of FIGS. 2A-2D, flange 214 extends from a surface of the crown 212, in a direction away from the leads generally along the direction of the x axis. The crown 212 and/or flange 214 are provided having an outer shape selected to increase creepage and clearance distances between the conductor 240 and the IC 220. In the example embodiment of FIGS. 2A-2B, flange 214 is provided having a square shape. It should, of course, be appreciated that flange 214 may be provided in any shape selected to suit the needs of a particular application including, but not limited to, a rectangular shape, a triangular shape, a round shape, an oval shape, or any regular or irregular geometric shape.

As best illustrated by FIGS. 2C-2D, the flange 214 includes an edge 218 that extends from a first major surface 232 to a second major surface 234. The edge 218 extends beyond the second major surface 234 of the flange 214 to form a lip or ridge that can be shaped or positioned to suit the needs of the particular application. As will be discussed in relation to later figures, the crown 212 and flange 214 can be positioned, shaped, or otherwise disposed between the conductor 240 and the exposed portion of the elongated leads 224 of the IC 220 to increase creepage and clearance distances between the low-voltage conductor of the IC 220 and the high-voltage conductor 240 proximate the IC 220.

FIG. 3 shows an IC 320 inserted through an opening or slot 302 in a voltage carrying conductor 340, which may be similar to or the same as IC 220 and conductor 240 in FIGS. 2A-2D. The IC 320 includes a package 322 disposed around a lead frame comprising a die attach pad and a plurality of elongated leads 324 extending in a single direction with respect to the die attach pad. A terminal end of each of the plurality of elongated leads 324 extends out of the package 322 generally along the direction of the -y axis and are coupled to conductors on a substrate 330. Such an IC 320 with elongated leads extending in a single direction is sometimes referred to as a single in-line package (SIP). Disposed over the IC 320 is an isolation structure 310 (which is made transparent in FIG. 3 so that IC 320 is visible). The isolation structure 310 has a shape configured to both accept (e.g., fit over) the IC 320 and increase creepage and clearance distances between the IC and the conductor 340. Disposing isolation structure 310 over IC 320 results in a voltage isolated IC package 300.

The isolation structure 310 includes a crown portion 312 (or more simply "crown 312"). The crown 312 is disposed over the IC 320 in the slot 302 through the conductor 340. The isolation structure 310 includes crown 312 having an opening therein with a shape selected such that crown 312 may be disposed over the IC 320.

The crown 312 has an outer shape selected to increase creepage and clearance distances between the conductor 340 and the IC 320. The crown 312 has an opening with a shape selected to cover the package 322 and substantially the majority of the surface area of the exposed portion of the plurality of elongated leads 324. The crown 312 extends generally through the direction of the -y axis from the conductor 340 towards the substrate 330, substantially covering the exposed portion of the elongated leads 324 of the IC 320, thus increasing the creepage and clearance distances between the conductor 340 and the IC 320.

For example, as illustrated by FIG. 3, in order to reach the exposed portion of the elongated leads 324, a spark 350 must travel from the conductor 340 past the crown 312 of the isolation structure 310. Thus, the isolation structure 310 further increases the distance from the conductor 340 to the exposed portion of the elongated leads 324. In embodiments, at least a portion of the crown 312 contacts a surface of substrate 330.

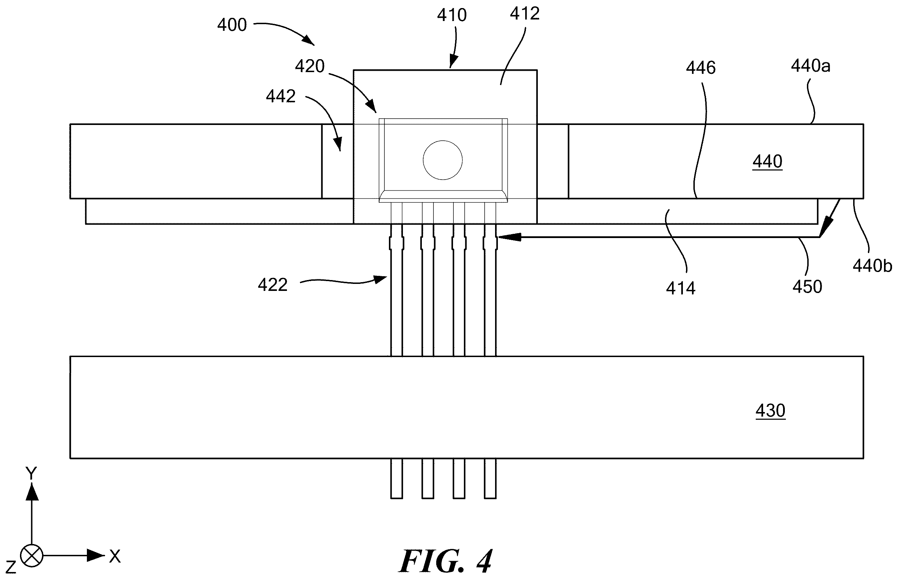

FIG. 4 is a voltage isolated IC package 400 including an isolation structure 410 disposed over an IC 420 between a substrate 430 and a conductor 440 having first and second opposing surfaces 440a, 440b. The isolation structure 410 includes a crown 412 and a flange 414. The crown 412 may extend partially or fully through a slot or opening 442 in conductor 440. Flange 414 is disposed proximate or adjacent to conductor surface 440b.

In embodiments, at least a portion of a surface 446 of flange 414 contacts at least a portion of conductor surface 440b. In the example embodiment of FIG. 4, substantially all of flange surface 446 contacts conductor surface 440b. That is, flange surface 446 may be contiguous with conductor surface 440b. With this approach, the path a spark must travel from conductor 440 to leads 422 is indicated by reference numeral 450.

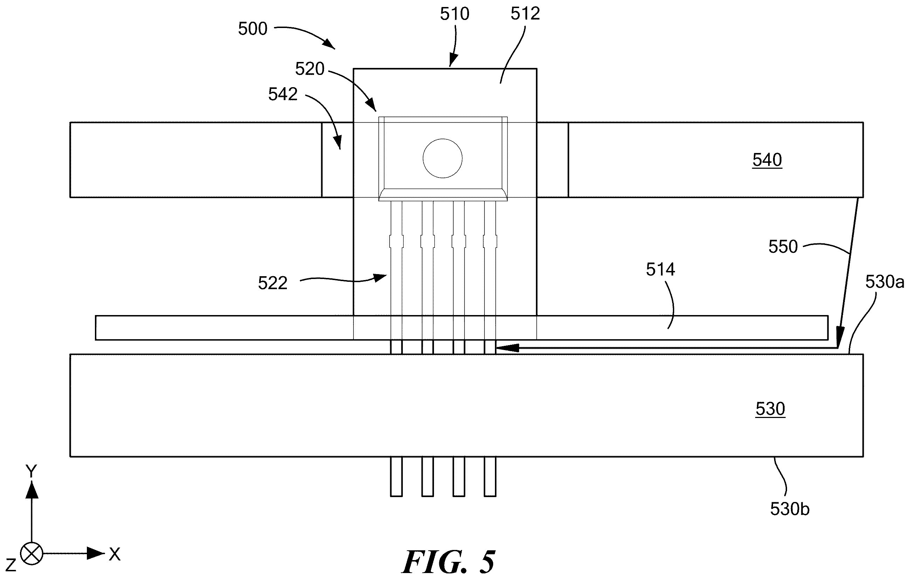

FIG. 5 is a voltage isolated IC package 500 including an isolation structure 510 disposed over an IC 520 between a substrate 530 having first and second opposing surfaces 530a, 530b and a conductor 540. The isolation structure 510 includes a crown 512 and a flange 514. The crown 512 may extend partially or fully through a slot or opening 542 in conductor 540. In embodiments, a surface of flange 514 is disposed proximate or adjacent substrate surface 530a. In embodiments, a surface of flange 514 is partially, substantially or fully in contact with substrate surface 530a. In the example embodiment of Fig. 5, a surface of flange 514 is adjacent to, but not in contact with the substrate 530. With the example embodiment illustrated in FIG.5, the path a spark must travel from conductor 540 to leads 522 is indicated by reference numeral 550.

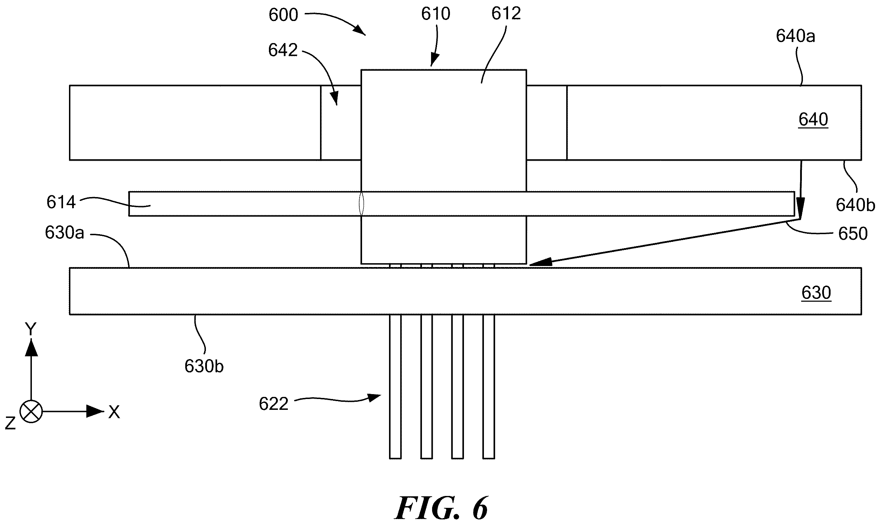

FIG. 6 is a voltage isolated IC package 600 including an isolation structure 610 disposed over an IC 620 between a substrate 630 having first and second opposing surfaces 630a, 630b and a conductor 640 having first and second opposing surfaces 640a, 640b. The isolation structure 610 includes a crown 612 and a flange 614. The crown 612 may extend partially or fully through a slot or opening 642 in conductor 640.

In embodiments, flange 614 extends from a center (or near center) of the crown 612. Thus, a surface of flange 614 is proximate or adjacent substrate surface 630a and conductor surface 640b. In the example embodiment of FIG. 6, the flange 614 is adjacent to, but not in contact with the substrate 630, nor the conductor 640, but is positioned approximately half way between substrate surface 630a and conductor surface 640b. The crown 512 may extend partially or fully through a slot or opening 642 in conductor 640. In embodiments, a surface of crown 612 is disposed proximate or adjacent substrate surface 630a. In embodiments, a surface of flange 612 is partially, substantially, or fully in contact with substrate surface 630a. In the example embodiment of Fig. 6, a surface of crown 612 is adjacent to, but not in contact with the substrate surface 630a. With this approach, the path a spark must travel from conductor 640 to leads 622 is indicated by reference numeral 650.

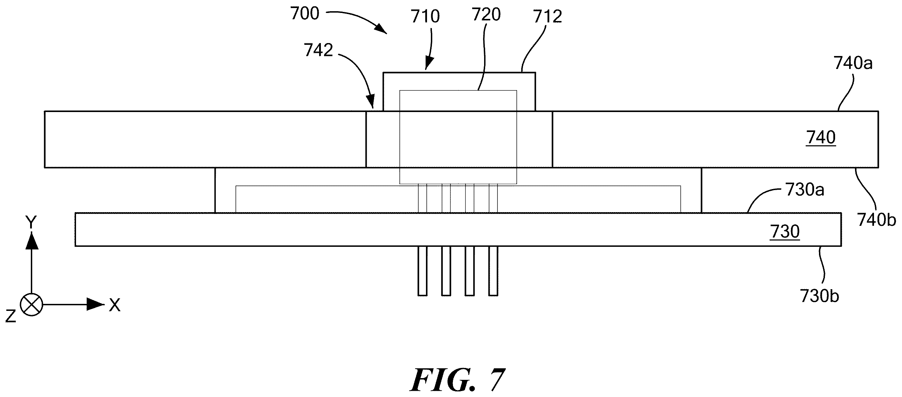

FIG. 7 is a voltage isolated IC package 700 including an isolation structure 710 disposed over an IC 720, between a substrate 730 having first and second opposing surfaces 730a, 730b and a conductor 740 having first and second opposing surfaces 740a, 740b. The isolation structure 710 including a crown 712 and a flange 714 having first and second opposing surfaces 714a, 714b. The crown 712 may extend partially or fully through a slot or opening 742 in conductor 740.

In embodiments, at least a portion of a surface 714a of flange 714 contacts at least a portion of conductor surface 740b and at least a portion of a surface 714b of flange 714 contacts at least a portion of substrate surface 730a. In the example embodiment of FIG. 7, substantially all of flange surface 714a contacts conductor surface 740b and substantially all of flange surface 714b contacts substrate surface 730a. That is, flange surfaces 714a, 714b may be contiguous with the substrate surface 730a and conductor surface 740b.

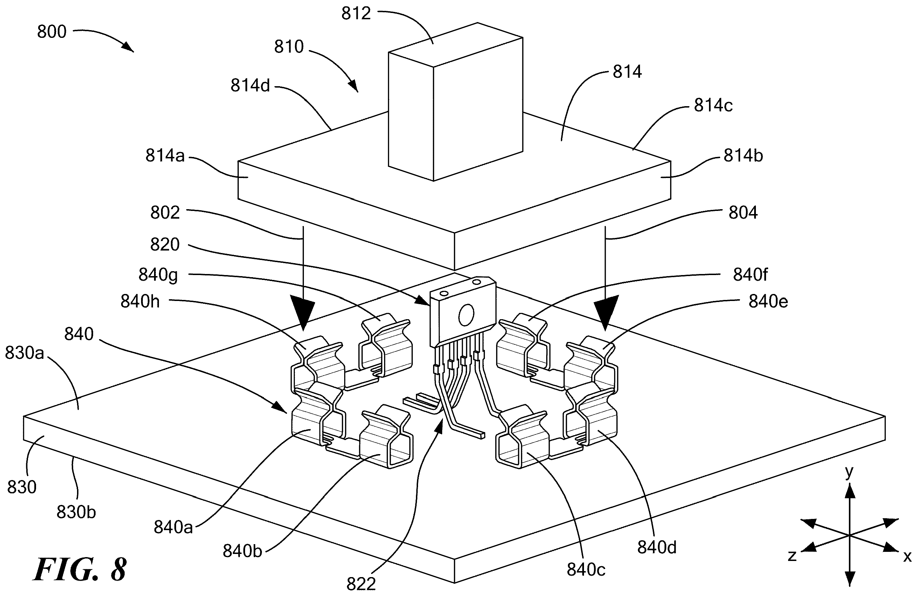

FIG. 8 shows an isolation structure 810 that may be disposed over an IC 820 (as indicated by arrows 802, 804) on a substrate 830 having first and second opposing surfaces 830a, 830b. The isolation structure 810, IC 820, and substrate 830 may be similar to or the same as isolation structure 210, IC 220, and substrate 230 of FIG. 2. A terminal end of each of the plurality of elongated leads 822 extends out of the package generally along the direction of the -y axis and are coupled to conductors on a substrate 830. The isolation structure 810 including a crown 812 and a flange 814 having edges 814a, 814b, 814c, 814d.

In embodiments, one or more clips 840a, 840b, 840c, 840d, 840e, 840f, 840g, 840h (generally denoted clips 840) are disposed on a portion of the substrate surface 830a and configured to accept and position the isolation structure 810 on the substrate surface 830a. In the example embodiment of FIG. 8, the clips 840 are disposed to align with the flange 814, such that one or more clips 840 (two clips 840 as shown in this example) align and can substantially contact respective ones of edges 814a, 814b, 814c, 814d. Clips 840a, 840b align and can substantially contact edge 814a, clips 840c, 840d align and can substantially contact edge 814b, clips 840e, 840f align and can substantially contact edge 814c, and clips 840g, 840h align and can substantially contact edge 814d. Accordingly, when isolation structure 810 is disposed substantially on the surface 830a of substrate 830, the clips 840 can alight and substantially contact the edge 814a, 814b, 814c, 814d to position and hold the isolation structure 810 in place.

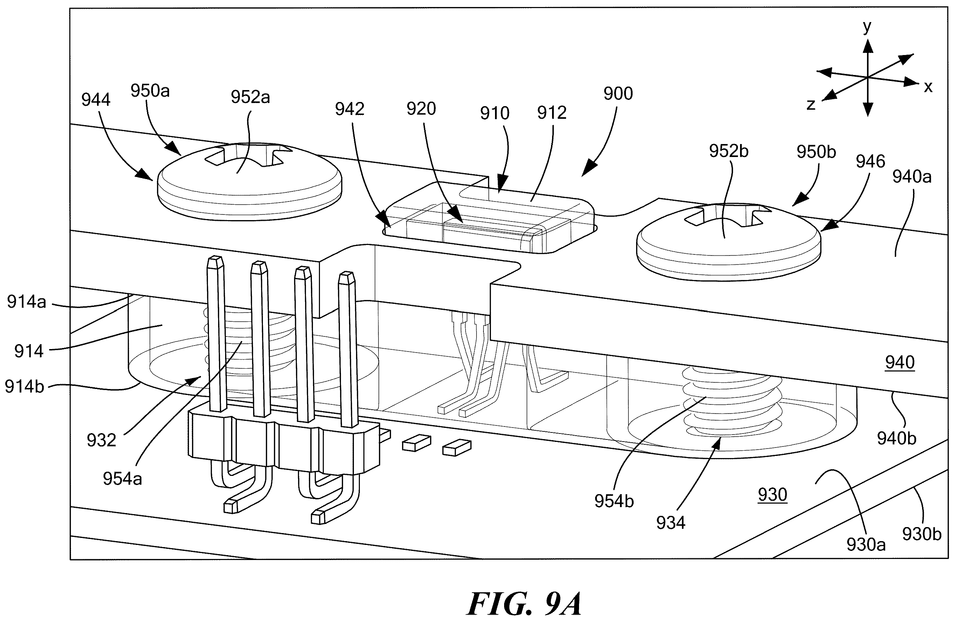

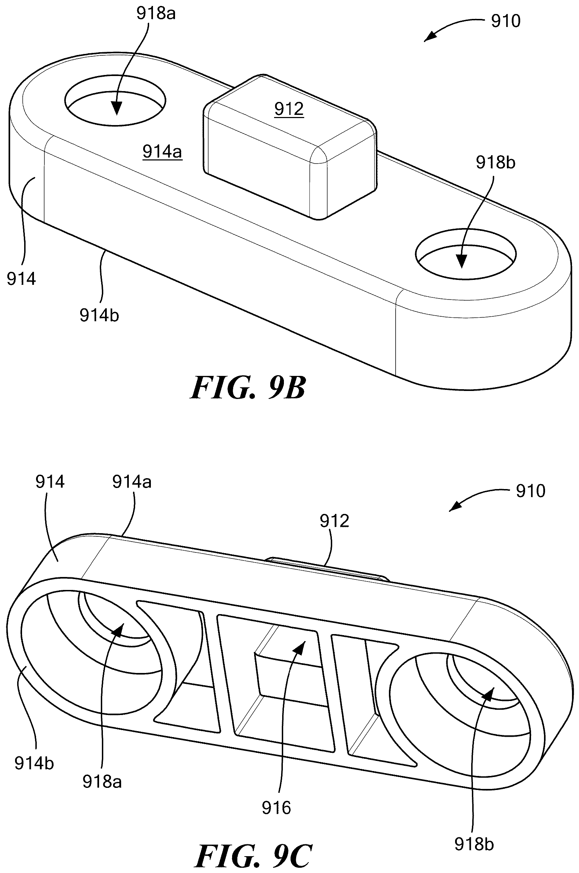

FIGS. 9A-9C show a voltage isolated IC package 900 including an isolation structure 910 disposed over an IC 920 between a substrate 930 having first and second opposing surfaces 930a, 930b and a conductor 940 having first and second opposing surfaces 940a, 940b. The isolation structure 910 including a crown 912 and a flange 914 having first and second opposing surfaces 914a, 914b. As may be most clearly seen in FIG. 9B, the crown projects above a surface 914a of flange 914. The crown 912 may extend partially or fully through a slot or opening 942 in conductor 940. The crown 912 has an opening 916 (FIG. 9C) therein. The opening 916 has a shape selected such that crown 912 may be disposed over the IC 920.

One or more removable or permanent fasteners 950a, 950b can secure and/or position the isolation structure 910, the conductor 940, and substrate 930 in relation to one another. In this example, embodiment fasteners 950a, 950b are illustrated as screws 950a, 950b having first and second heads 952a, 952b and first and second bodies 954a, 954b. The screws 950a, 950b may be commercial off-the-shelf parts. Other fasteners including, but not limited to rivets, bolts, buckles, buttons, cable ties, may of course, be used. Other fastening techniques may also be used, including but not limited to adhesives, epoxy, glue. Such fastening techniques may also be used with any of the isolation structures described herein.

In this example embodiment, first and second screws 950a, 950b extend in a direction along the -y axis and are disposed in slots or openings 944, 946 in the conductor 940 that extend from the first opposing surface 940a to the second opposing surface 940b, slots or openings 932, 934 in the substrate 930 that extend from the first opposing surface 930a to the second opposing surface 930b, and slots or openings 918a, 918b in the isolation structure 910 that extend from the first opposing surface 914a to the second opposing surface 914b (FIGS. 9B-9C). A head 952a of first screw 950a is disposed on a surface 940a of the conductor 940 and a body 954a is disposed through first slot 944 in the conductor 940, first slot 932 in substrate 930, and first slot 918a in isolation structure 910. A head 952b of second screw 950b is disposed on a surface 940a of conductor 940 and a body 954b is disposed through second slot 946 in the conductor 940, second slot 934 in substrate 930, and second slot 918b in isolation structure 910.

In embodiments, the screws 950a, 950b can be tightened, such that the isolation structure 910 can be substantially in contact with the conductor 940 and substrate 930. At least a portion of a surface 914a of flange 914 substantially contacts at least a portion of conductor surface 940b and at least a portion of a surface 914b of flange 914 substantially contacts at least a portion of substrate surface 930a. In the example embodiment of FIG. 9, substantially all of flange surface 914a contacts conductor surface 940b and substantially all of flange surface 914b contacts substrate surface 930a. That is, flange surfaces 914a, 914b may be contiguous with the substrate surface 930a and conductor surface 940b.

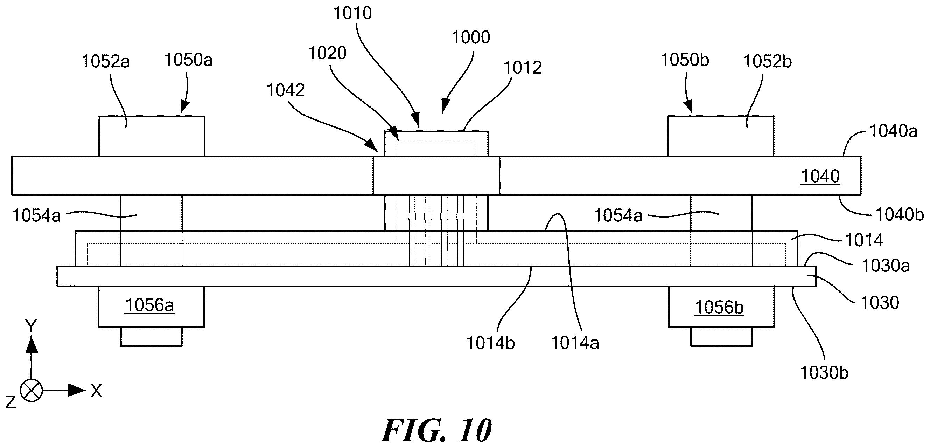

FIG. 10 is a voltage isolated IC package 1000 including an isolation structure 1010 disposed over an IC 1020 between a substrate 1030 having first and second opposing surfaces 1030a, 1030b and a conductor 1040 having first and second opposing surfaces 1040a, 1040b. The isolation structure 1010 including a crown 1012 and a flange 1014 having first and second opposing surfaces 1014a, 1014b. The crown 1012 may extend partially of fully through a slot or opening 1042 in conductor 1040.

One or more fasteners 1050a, 1050b can be help secure or position the isolation structure 1010, the conductor 1040, and substrate 1030 in relation to one another. The fasteners 1050a, 1050b can be provided as screws having first and second heads 1052a, 1052b, first and second bodies 1054a, 1054b, and first and second bolts 1056a, 1056b. The bolts 1056a, 1056b can be tightened, such that the isolation structure 910 can be substantially in contact with the substrate 930.

In embodiments, first and second screws 1050a, 1050b extend in a direction along the -y axis and are disposed in slots or openings in the conductor 1040, slots or openings in the substrate 1030, and slots or openings in the isolation structure 1010. A head 1052a of first screw 1050a is disposed on a surface 1040a of the conductor 1040, a body 1054a is disposed through the conductor 1040, substrate 1030, and isolation structure 1010, and a bolt 1056a is disposed on a surface 1030b of the substrate 1030. A head 1052b of second screw 1050b is disposed on a surface 1040a of conductor 1040, a body 1054b is disposed through the conductor 1040, substrate 1030, and isolation structure 1010, and a bolt 1056a is disposed on a surface 1030b of the substrate 1030.

In embodiments, the screws 1050a, 1050b can be tightened, such that the isolation structure 1010 can be substantially in contact with the conductor 1040 and substrate 1030. At least a portion of a surface 1014b of flange 1014 contacts at least a portion of substrate surface 1030a. In the example embodiment of FIG. 10, substantially all of flange surface 1014b contacts substrate surface 1030a, while the flange surface 1014b does not contact conductor surface 1040b. That is, flange surface 1014b may be contiguous with the substrate surface 1030a.

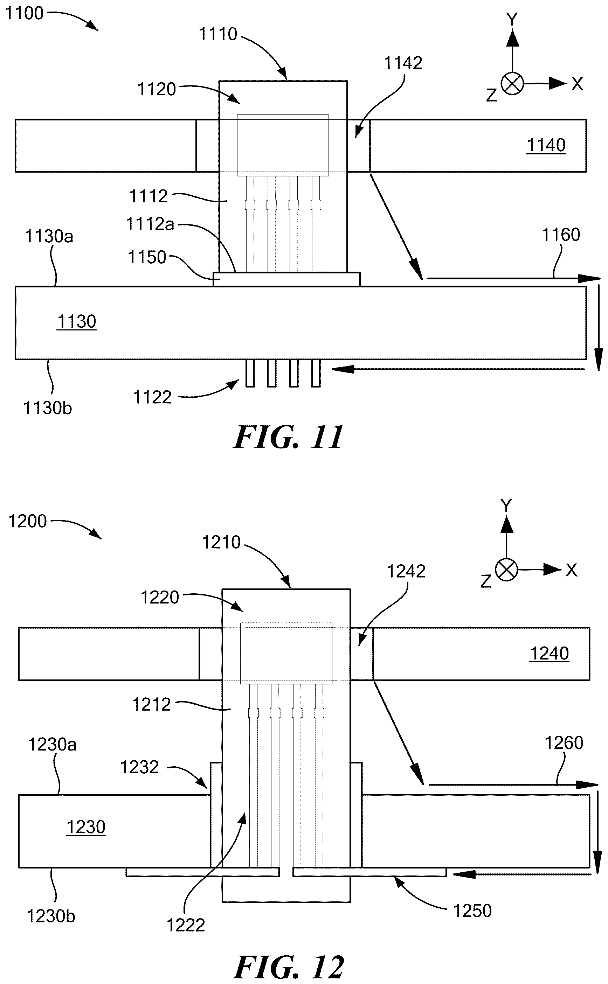

FIG. 11 shows a voltage isolated IC package 1100 including an isolation structure 1110 disposed over an IC 1120 between a substrate 1130 having first and second opposing surfaces 1130a, 1130b and a conductor 1140. The isolation structure 610 includes a crown 1112 having a surface 1112a. The crown 1112 may extend partially or fully through a slot or opening 1142 in conductor 1140.

In embodiments, an adhesive 1150 is disposed on at least a portion of the surface 1112a of crown 1112 and on at least a portion of first opposing surface 1130a of substrate 1130. The adhesive 1150 can further position and secure the isolation structure 1110. In the example embodiment of FIG. 11, substantially all of surface 1112a contacts adhesive 1150 and a portion of surface 1130a contacts adhesive 1150. That is, adhesive may be contiguous with the surface 1112a and surface 1130a to secure the isolation structure 1110 to substrate 1130 and position the crown 1112 in the opening 1142 in conductor 1140. With this approach, the path a spark must travel from conductor 1140 to leads 1122 is indicated by reference numeral 1160.

FIG. 12 shows a voltage isolated IC package 1200 including an isolation structure 1210 disposed over an IC 1212 between a substrate 1230 having first and second opposing surfaces 1230a, 1230b and a conductor 1240. The isolation structure 1210 includes a crown 1212. The crown 1212 may extend partially or fully through a slot or opening 1242 in conductor 1240 and partially of fully through a slot or opening 1232 in substrate 1230.

In embodiments, an adhesive 1250 is disposed on at least a portion of the surface 1212a of crown 1220 that extends into the substrate 1230 and on at least a portion of first and second opposing surfaces 1230a, 1230b of substrate 1230. In the example embodiment of FIG. 12, adhesive may be contiguous with the side surfaces of the crown 1212 and first and second opposing surfaces 1230a, 1230b of substrate 1230 to secure the isolation structure 1210 to substrate 1230 and position the crown 1212 in the opening 1242 in conductor 1240. With this approach, the path a spark must travel from conductor 1240 to leads 1222 is indicated by reference numeral 1260.

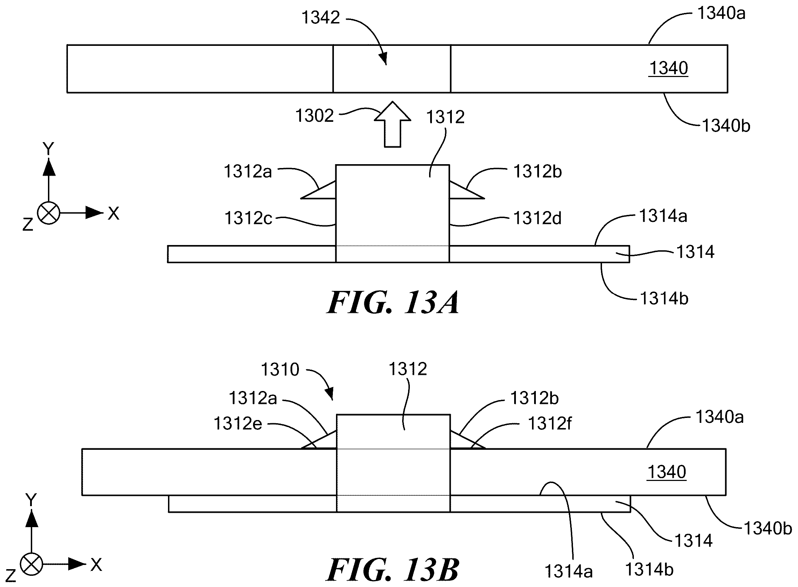

FIGS. 13A-13C in which like elements are provided having like reference designations throughout the several views, shown is an example embodiment of a method to couple (or otherwise connect or install) a voltage isolated IC package 1300 to a structure 1340 which may, for example be a conductor or bus bar such as one of the conductors described above in conjunction with FIGS. 1-12. In FIG. 13A, an isolation structure 1310 can be disposed through a slot 1342 in a conductor 1340 having first and second opposing surfaces 1340a, 1340b, as indicated by arrow 1302. The isolation structure 1310 includes a crown 1312 and a flange 1314 having first and second opposing surfaces 1314a, 1314b.

In example embodiments of FIGS. 13A-13C, the crown 1312 has one or more fasteners 1312a, 1312b that position and/or secure the isolation structure 1310 (e.g., the one or more fasteners 1312a, 1312b perform a securing or locking function to secure isolation structure to conductor 1340). In this example embodiment a pair of fasteners 1312a, 1312b are used. In some embodiments, one or more fasteners may be used. In some embodiments, the one or more fasteners may be provided as one or more of spring clips, snap fits, and J-clips or any other type of clip. Other types of securing mechanisms or connecting structures (e.g., one or more detents or detent-like structures) may, of course, also be used. In this example embodiment, fasteners 1312a and 1312b are disposed on opposing sides of crown 1312.

In FIG. 13B, an isolation structure 1310 is disposed into the slot 1342 in a conductor 1340. At least a portion of a first surface of fastener 1312a and a portion of a surface of fastener 1312b contact at least a portion of conductor surface 1340a. At least a portion of a surface 1314a of flange 1314 contacts at least a portion of conductor surface 1340b. In the example embodiment of FIG. 13B, substantially all of flange surface 1314a contacts conductor surface 1340b and substantially all of fastener surfaces contact conductor surface 1340a. That is, flange surfaces 1314a may be contiguous with the conductor surface 1340b and fastener surfaces may be contiguous with the conductor surface 1340a (as may be most clearly seen in FIG. 13B).

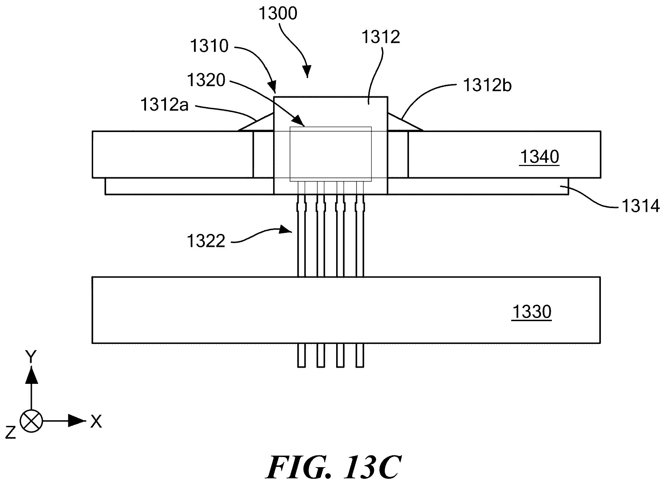

In FIG. 13C, the IC 1320 is disposed in an opening in the crown 1312 of the isolation structure 1310. Disposing isolation structure 1310 over IC 1320 results in a voltage isolated IC package 1300. A terminal end of each of the plurality of elongated leads 1322 of IC 1320 extend out of the package 1322 generally along the direction of the -y axis and are coupled to conductors on a substrate 1330.

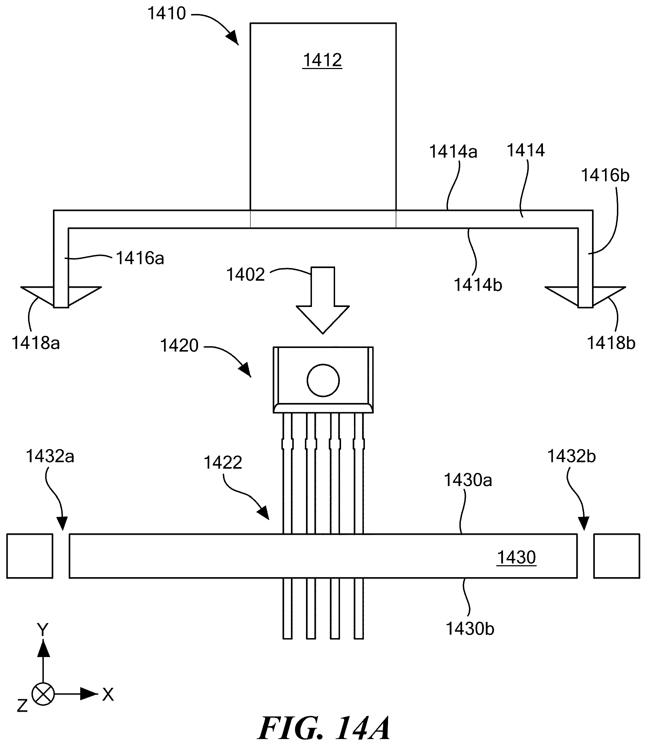

FIGS. 14A-14C show an example embodiment of a method for installing a voltage isolated IC package 1400. In FIG. 14A, an isolation structure 1410 can be disposed over an IC 1420, as indicated by arrow 1402. A terminal end of each of the plurality of elongated leads 1422 of IC 1420 extend out generally along the direction of the -y axis and are coupled to conductors on a substrate 1430 having first and second opposing surfaces 1430a, 1430b. The substrate 1430 includes a plurality of slots or openings 1432a, 1432b that extend from the first opposing surface 1430a to the second opposing surface 1430b.

The isolation structure 1410 includes a crown 1412 and a flange 1414 having first and second opposing surfaces 1414a, 1414b. In an embodiment, the isolation structure 1410 includes attachment structures 1416a, 1416b that can further position and secure the isolation structure 1410 in relation to the conductor 1440 and substrate 1430. The attachment structures 1416a, 1416b are disposed on opposing sides of the isolation structure 1410 and extend from the second opposing surface 1414b of the flange 1414 generally along the direction of the -y axis. In an embodiment, attachment structures 1416a, 1416b further comprise fasteners 1418a, 1418b which may, for example, be provided as any type of fastener described herein.

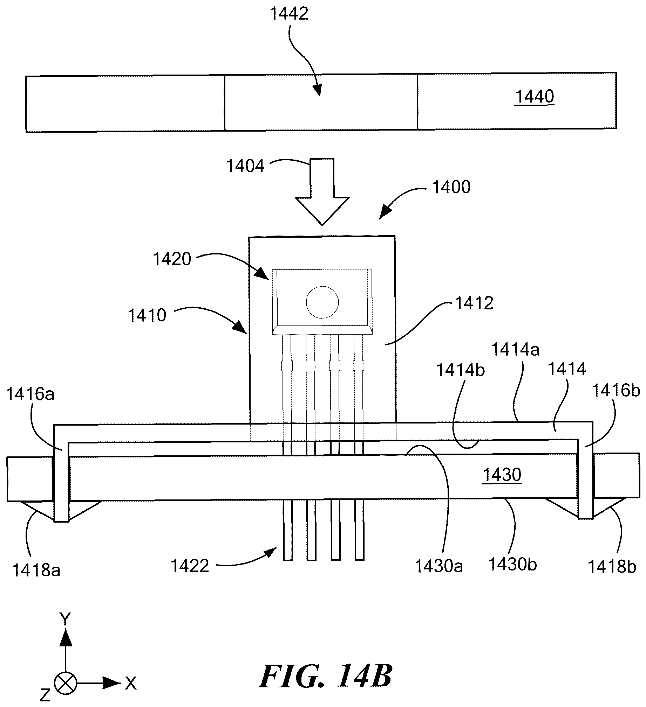

As shown in FIG. 14B, with the packaged IC 1400 coupled to PCB 1430 and the isolation structure 1410 disposed over the IC and coupled to PCB 1430, the PCB assembly (i.e., the combination of packaged IC 1400, isolation structure 1410 and PCB 1430) may be positioned (as indicated by arrow 1404) such that isolation structure 1410 can be disposed in a slot or opening 1442 of conductor 1440. Disposing isolation structure 1410 over IC 1420 results in a voltage isolated IC package 1400. The IC 1420 is disposed in an opening in the crown 1412 of the isolation structure 1410. Flange 1414 is disposed proximate or adjacent to the substrate surface 1430a. In embodiments, the flange 1414 is adjacent to, but not in contact with the substrate 1430.

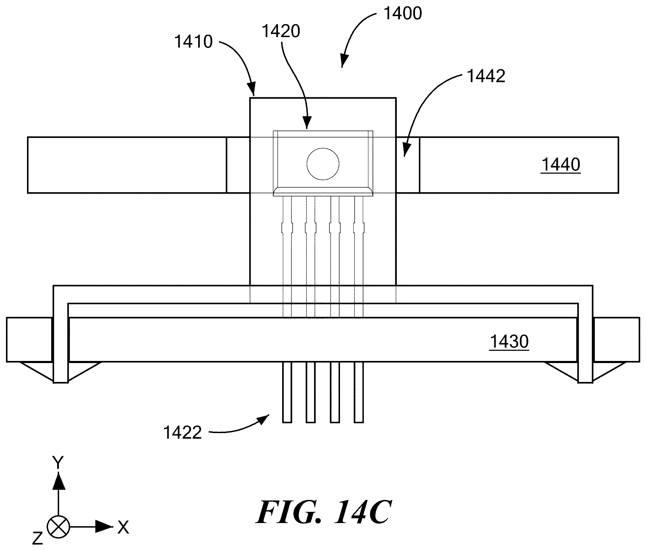

The attachment structures 1416a, 1416b are disposed in slots 1432a, 1432b. Attachment structure 1416a is disposed in slot 1432a and attachment structure 1416b is disposed in slot 1432b. A substantial portion of a surface of extended portions 1418a, 1418b, 1418c, 1418d contacts substrate surface 1430b. That is, the surfaces of fasteners 1418a, 1418b, 1418c, 1418d may be contiguous with the substrate surface 1430b. In FIG. 14C, the isolation structure 1410 is disposed in slot or opening 1442 in the conductor 1440.

Various embodiments of the concepts, systems, devices, structures, and techniques sought to be protected are described herein with reference to the related drawings. Alternative embodiments can be devised without departing from the scope of the concepts, systems, devices, structures and techniques described herein. It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures, and techniques are not intended to be limiting in this respect. Accordingly, a coupling of entities can refer to either a direct or an indirect coupling, and a positional relationship between entities can be a direct or indirect positional relationship.

The following definitions and abbreviations are to be used for the interpretation of the claims and the specification.

The terms "connection," "coupled to" or variants thereof can include an indirect "connection" (or coupling) and a direct "connection" (or coupling). As an example of an indirect positional relationship, references in the present description to disposing, arranging or placing element "A" over element layer "B" include situations in which one or more intermediate elements (e.g., element "C") is between element "A" and element "B" as long as the relevant characteristics and functionalities of elements "A" and "B" are not substantially changed by the intermediate elements.

Similarly, the term "direct contact" means that a first element, such as a first structure, and a second element, such as a second structure, are connected without any intermediary element or structure.

As used herein, the terms "comprises," "comprising," "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Additionally, the term "exemplary" is used herein to mean "serving as an example, instance, or illustration." Any embodiment or design described herein as "exemplary" is not necessarily to be construed as preferred or advantageous over other embodiments or designs.

The terms "one or more" and "at least one " are understood to include any integer number greater than or equal to one, i.e. one, two, three, four, etc.

The term "a plurality" is understood to include any integer number greater than or equal to two, i.e. two, three, four, five, etc.

References in the specification to "one embodiment," "an embodiment," "an example embodiment," etc., indicate that the embodiment described can include a particular feature, structure, or characteristic, but every embodiment can include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

For purposes of the description hereinafter, the terms "upper," "lower," "right," "left," "vertical," "horizontal," "top," "bottom," and derivatives thereof shall relate to the described structures and methods, as oriented in the drawing figures. The terms "overlying," "atop," "on top," "positioned on" or "positioned atop" mean that a first element, such as a first structure, is present on a second element, such as a second structure, where intervening elements such as an interface structure can be present between the first element and the second element.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

The terms "approximately," "substantially" and "about" may be used to mean within ±20% of a target value in some embodiments, within ±10% of a target value in some embodiments, within ±5% of a target value in some embodiments, and yet within ±2% of a target value in some embodiments. For example, the terms "substantially equal" or "substantially equal to" may be used to refer to values that are within ±20% of one another in some embodiments, within ±10% of one another in some embodiments, within ±5% of one another in some embodiments, and yet within ±2% of one another in some embodiments. The terms "approximately," "substantially" and "about" may include the target value.

The term "substantially" may also be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

It is to be understood that the disclosed subject matter is not limited in its application to the details of construction and to the arrangements of the components set forth in the following description or illustrated in the drawings. The disclosed subject matter is capable of other embodiments and of being practiced and carried out in various ways. Also, it is to be understood that the phraseology and terminology employed herein are for the purpose of description and should not be regarded as limiting. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

## Claims

1. An isolation structure, comprising:
a crown having an opening therein with the opening having a shape selected such that the crown may be disposed over an integrated circuit (IC), the crown having an outer shape selected to increase creepage and clearance distances between a low-voltage conductor of an IC and a high-voltage conductor proximate the IC.

2. The isolation structure of claim 1, further comprising a flange that extends from a surface of the crown in a direction away from a surface of the IC, wherein an outer shape of the crown and an outer shape of the flange are selected to increase creepage and clearance distances between a low-voltage conductor of the IC and a high-voltage conductor proximate the IC.

3. The isolation structure of claim 2, wherein the flange further comprises one or more clips to position and hold the isolation structure.

4. The isolation structure of claim 2, further comprising one or more screws that extend through the flange to position the isolation structure in relation to the IC and the high-voltage conductor.

5. The isolation structure of claim 1, wherein the crown further comprises one or more extended portions to position and hold the isolation structure.

6. The isolation structure of claim 1, further comprising an adhesive material disposed on the crown.

7. A voltage isolated integrated circuit (IC) package, comprising:
an IC, wherein the IC comprises:
a lead frame comprising a die attach pad and a plurality of elongated leads extending in a single direction with respect to the die attach pad;
a semiconductor die comprising a first surface attached to the die attach pad and a second, opposing surface; and
a plurality of magnetic field sensing elements disposed on the second, opposing surface of the semiconductor die; and
an isolation structure according to any of claims 1 to 6, wherein the crown is disposed over the IC.

8. A configuration, comprising:
a substrate;
an integrated circuit (IC) disposed adjacent to the substrate, wherein the IC comprises:
a lead frame comprising a die attach pad and a plurality of elongated leads extending in a single direction with respect to the die attach pad, wherein a terminal end of each of the plurality of elongated leads is attached to the substrate;
a semiconductor die comprising a first surface attached to the die attach pad and a second, opposing surface; and
a plurality of magnetic field sensing elements disposed on the second, opposing surface of the semiconductor die;
a conductor having a first major surface, a second opposing major surface, and a slot extending through the conductor from the first major surface to the second opposing major surface, wherein the semiconductor die extend through the slot and each of the plurality of magnetic field sensing elements is configured to sense a magnetic field generated by a current through the conductor; and
an isolation structure comprising a crown disposed over the IC between the conductor and the semiconductor die, the isolation structure having a shape configured to increase creepage and clearance distances between the IC and the conductor.

9. The configuration of claim 8, wherein the isolation structure further comprises a flange that extends from a surface of the crown in a direction away from a surface of the IC, wherein an outer shape of the crown and an outer shape of the flange are selected to increase creepage and clearance distances between the IC and the conductor.

10. The configuration of claim 9, wherein the flange is disposed on the second opposing major surface of the conductor, on a first surface of the substrate, between the second opposing major surface of the conductor and a first surface of the substrate, or on the second opposing major surface of the conductor and on a first surface of the substrate.

11. The configuration of claim 9, further comprising one or more clips disposed on the first surface of the substrate and attached to the flange to position and hold the isolation structure.

12. The configuration of claim 9, further comprising one or more screws that extend from a second surface of the substrate to the first surface of the substrate, through the flange, and the first major surface and the second opposing major surface of the conductor to position and hold the isolation structure.

13. The configuration of claim 9, wherein the substrate further comprises a plurality of slots that extend from a first surface of the substrate to a second surface of the substrate and the flange further comprises a plurality of pillars with one or more extended portions disposed on the second surface of the substrate to position and hold the isolation structure.

14. The configuration of claim 9, wherein the substrate further comprises a slot that extends from a first surface of the substrate to a second surface of the substrate, wherein the crown extends through the slot and the plurality of elongated leads extend through the slot and the terminal end of each of the plurality of elongated leads attach to the second surface of the substrate.

15. The configuration of claim 8, wherein the crown further comprises one or more extended portions disposed on the first major surface to position and hold the isolation structure.
